# EUROPÄISCHE PATENTSCHRIFT

(11) **EP 2 802 481 B1**
(45) Veröffentlichungstag und Bekanntmachung des Hinweises auf die Patenterteilung: **21.10.2015**
(21) Anmeldenummer: 13700252.3
(22) Anmeldetag: 05.01.2013
(51) Int. Cl.: B60N 2/235

(54) **BESCHLAG FÜR EINEN FAHRZEUGSITZ, SOWIE FAHRZEUGSITZ**
FITTING FOR A VEHICLE SEAT AND VEHICLE SEAT
FERRURE POUR UN SIÈGE DE VÉHICULE AINSI QUE LE SIÈGE DE VÉHICULE

(30) Priorität: 12.01.2012 DE 102012000776; 21.03.2012 DE 102012005963
(43) Veröffentlichungstag der Anmeldung: 19.11.2014
(73) Patentinhaber: Johnson Controls Components GmbH & Co. KG, 67657 Kaiserslautern (DE)
(72) Erfinder: PETERS, Christoph, 42929 Wermelskirchen (DE)
(74) Vertreter: Liedhegener, Ralf
(86) Internationale Anmeldenummer: PCT/EP2013/000016
(87) Internationale Veröffentlichungsnummer: WO 2013/104532

(56) Entgegenhaltungen:
- WO-A1-2004/043733
- DE-A1- 19 928 148

## Beschreibung

Die Erfindung betrifft einen Beschlag für einen Fahrzeugsitz mit den Merkmalen des Oberbegriffs des Anspruches 1 sowie einen Fahrzeugsitz.

### Stand der Technik

Zur vollständigen Spielreduzierung bei bekannten, gattungsgemäßen Beschlägen, ist neben dem Führungsspiel der Riegel auch ein Lagerspiel des Beschlages in der Lagerstelle, insbesondere zwischen einem Zahnkranz des zweiten Beschlagteils und Führungssegmenten des ersten Beschlagteils, auszugleichen.

Die EP 1 928 691 B1 offenbart eine Möglichkeit der Spielreduzierung für einen Rastbeschlag mit vier Riegeln. Zur Festigkeitssteigerung und Spielreduzierung sind vier gegensinnig kippende Riegel vorgesehen. Dieses Prinzip zur Spielreduzierung wirkt ausreichend bei einem Rastbeschlag mit drei oder vier Riegeln, bei dem die Riegel aufgrund ihrer Anordnung entlang des Umfangs des Beschlages ein Lagerspiel des Beschlages ausgleichen können, indem die Riegel in unterschiedlichen Richtungen statisch bestimmt oder überbestimmt Kräfte auf den Zahnkranz erzeugen. Bei einem Rastbeschlag mit nur einem oder zwei Riegeln ist dies aufgrund einer statischen Unterbestimmtheit nicht vollständig möglich, was sich ungünstig auf die Wirksamkeit dieser vorbekannten Art der Spielreduzierung auswirkt.

Aus der DE 10 2007 059 510 C5 ist ein Verriegelungselement einer Verriegelungsvorrichtung bekannt, das aus einzelnen, miteinander verbundenen Lamellen besteht. Dadurch kann in einer Art Baukastensystem eine Anpassung der Bauteildicke an produktspezifische Lastanforderungen erfolgen. Die Lamellenbauweise hat jedoch keinen Einfluss auf eine Spielreduzierung der Verriegelungsvorrichtung.

Die DE 202 20 200 U1 offenbart einen beidseitig wirkenden Antrieb zur Drehung eines mit einer Verstellvorrichtung verbundenen Antriebsrades und einer Klinke, die zur Drehmomentübertragung mit dem Antriebsrad zusammenwirkt. Die Klinke weist dazu diametral einander gegenüberliegende Verzahnungsbereiche auf, die mit einer Innenverzahnung des Antriebsrades zusammenwirken. Die Klinke greift entweder mit einem der beiden Verzahnungsbereiche in die Innenverzahnung des Antriebsrades ein oder beide Verzahnungsbereiche sind außer Eingriff. Eine Spielreduzierung durch ein Eingreifen beider Verzahnungsbereiche in die Innenverzahnung ist nicht möglich.

Ein gattungsgemässer Beschlag ist aus dem Dokument DE19928148A bekannt.

### Aufgabe

Der Erfindung liegt die Aufgabe zu Grunde, einen Beschlag der eingangs genannten Art zu verbessern, insbesondere eine Möglichkeit zur effektiven Spielreduzierung bei Beschlägen mit einem oder zwei Riegeln zu schaffen, sowie einen entsprechenden Fahrzeugsitz bereitzustellen.

### Lösung

Diese Aufgabe wird erfindungsgemäß durch einen Beschlag mit den Merkmalen des Anspruches 1 und einen Fahrzeugsitz mit den Merkmalen des Anspruches 10 gelöst.

Dadurch dass der wenigstens eine Riegel aus einem ersten Riegelteil und einem zweiten Riegelteil besteht und jedes der Riegelteile eine Verzahnung zum Zusammenwirken mit einem Zahnkranz des zweiten Beschlagteils aufweist, steht ein optimierter Spielausgleich zur Verfügung.

Vorteilhafte Ausgestaltungen der Erfindung sind Gegenstand der abhängigen Ansprüche.

Das erste Riegelteil und das zweite Riegelteil werden durch einen Exzenter, der jeweils einen Riegelnocken der beider Riegelteile beaufschlagt, gegeneinander in der Führung verkippt und verspannt. Dazu beaufschlagt der Exzenter in einer bevorzugten Ausführungsform über Exzenternocken die beiden Riegelteile in unterschiedliche Richtungen mit jeweils einer Kraft, so dass die beiden Riegelteile mit Drehmomenten in zueinander entgegengesetzter Drehrichtung um jeweils einen Kontaktpunkt zwischen dem erstem Riegelteil und dem Zahnkranz und um einen Kontaktpunkt zwischen dem zweitem Riegelteil und dem Zahnkranz beaufschlagt werden.

Idealerweise wird die Verzahnung der Riegelteile so modifiziert, das jede einzelne Verzahnung eines Riegelteils einen definierten Tragpunkt zur Verzahnung des Zahnkranzes des zweiten Beschlagteils besitzt. Dadurch wird gegenüber einem einteiligen Riegel eine bessere Zahnüberdeckung erreicht, wodurch die Festigkeit gesteigert wird. Weiterhin wird durch das Verkippen der Riegelteile in der Führungsbahn eine Spielreduzierung erreicht. Durch ein gegensinniges Verkippen der Riegelteile werden die hierzu notwendigen Steuerwege reduziert. Dadurch ist es möglich, die kompletten auftretenden Führungstoleranzen auszugleichen. Besonders geeignet sind Ausführungsformen, bei denen der Grundkreisradius der Verzahnungen der Riegelteile gegenüber dem Grundkreisradius des Zahnkranzes des zweiten Beschlagteils kleiner ist.

Der wenigstens eine Riegel ist entlang einer Teilungslinie in die zwei Riegelteile geteilt. Die Teilungslinie weicht vorzugsweise in Teilbereichen von der radialen Richtung ab, so dass die beiden Riegelteile in radialer Richtung weitgehend formschlüssig miteinander verbunden sind. Ein Relativbewegung der beiden Riegelteile in Umfangsrichtung in einer über das Führungsspiel hinausgehenden Größenordnung wird durch Führungssegmente des ersten Beschlagteils verhindert.

Für die Entriegelung des Beschlages ist vorzugsweise eine Steuerscheibe vorhanden, welche drehfest mit dem Exzenter verbunden ist und mit einer Nase des wenigstens einen Riegels zusammenwirkt, um beim Entriegeln den Zahnkranz und den wenigstens einen Riegel außer Eingriff zu bringen. Aufgrund des zuvor beschriebenen Formschlusses zwischen den beiden Riegelteilen ist es ausreichend, wenn nur einer der beiden Riegelteile des Riegels eine Nase aufweist. Der andere Riegelteil wird dann über den Formschluss mitgenommen.

Zur Vermeidung von Kippmomenten ist es vorteilhaft, wenn die mit der Steuerscheibe zusammenwirkende Nase in Umfangsrichtung in der Mitte des Riegels liegt. Die Teilungslinie des Riegels ist in diesem Fall bevorzugt an der Nase vorbeigeführt.

Die Festigkeitssteigerung kann besonders gut ausgenutzt werden, wenn das erste Beschlagteil und das zweite Beschlagteil axial mittels eines Umklammerungsringes zusammengehalten werden. An diesen Umklammerungsring sind aufgrund des erfindungsgemäßen Spielausgleichkonzeptes nur geringe Toleranzanforderungen zu stellen.

Die beschriebene Spielreduzierung ist für Beschläge mit einer beliebigen Anzahl geteilter Riegel größer oder gleich eins anwendbar. Besonders vorteilhaft wirkt die Spielreduzierung in Beschlägen mit genau zwei Riegeln, von denen jeder aus einem ersten Riegelteil und einem zweiten Riegelteil besteht.

Zur Kostenoptimierung kann es sinnvoll sein, wenn nicht alle Riegel geteilt sind. Beispielsweise könnten bei einem Beschlag mit einer Anzahl von n Riegeln einer der n Riegel ungeteilt und n-1 Riegel geteilt ausgeführt sein.

### Figuren und Ausführungsformen der Erfindung

Im Folgenden ist die Erfindung anhand eines in den Figuren dargestellten vorteilhaften Ausführungsbeispiels näher erläutert. Es zeigen:
- Fig. 1: eine schematische Darstellung eines Fahrzeugsitzes gemäß Ausführungsbeispiel,
- Fig. 2: einen Schnitt durch den Fahrzeugsitz in einer Ebene zwischen Steuerscheibe und Kulisse,
- Fig. 3: eine Fig. 2 entsprechende Explosionsdarstellung,
- Fig. 4: einen Fig. 2 entsprechenden Schnitt, jedoch ohne Steuerscheibe und mit mehreren, die Bewegungsrichtungen der Riegelteile bei einer Verriegelung darstellenden Pfeilen sowie allen möglichen Kontaktpunkten,
- Fig. 5: einen Fig. 4 entsprechenden Schnitt mit einer Darstellung der wirksamen Kräfte und Kontaktpunkte bei der Verriegelung und
- Fig. 6: einen Fig. 4 entsprechenden Schnitt mit einer Darstellung der wirksamen Kräfte und Kontaktpunkte bei höherer Belastung, insbesondere im Crashfall

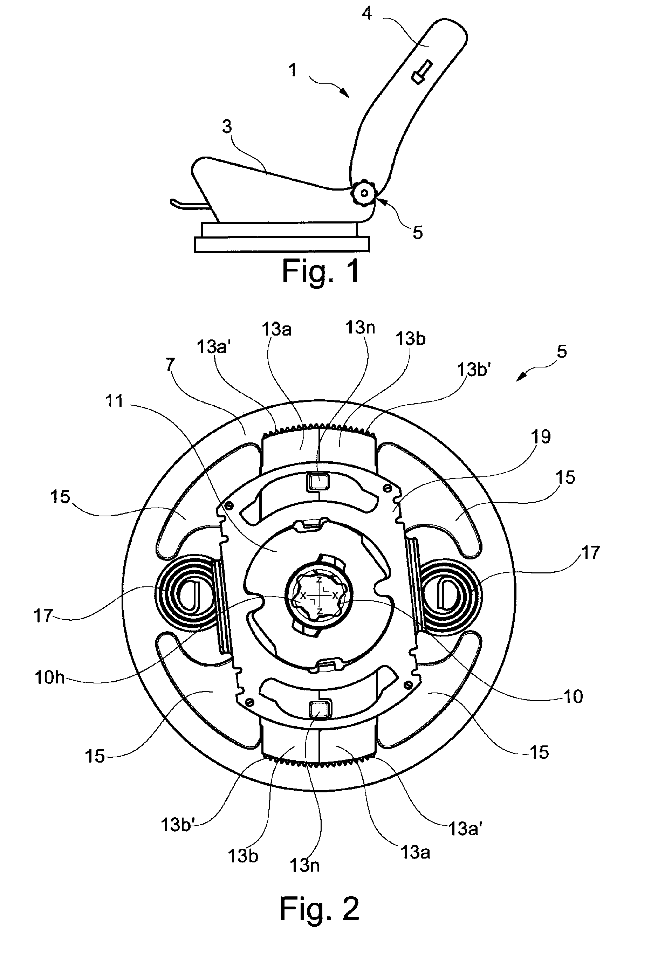

Ein in Fig. 1 dargestellter Fahrzeugsitz 1 eines Kraftfahrzeuges weist ein Sitzteil 3 und eine Lehne 4 auf, welche mittels zweier Beschläge 5 seitlich am Sitzteil 3 angebracht, relativ zu diesem um eine horizontal und senkrecht zur Fahrtrichtung verlaufende Achse A schwenkbar und in unterschiedlichen Neigungseinstellungen verriegelbar ist. Die Achse A, die zwischen den beiden Beschlägen 5 verläuft, definiert die nachfolgend verwendeten Richtungsangaben eines Zylinderkoordinatensystems.

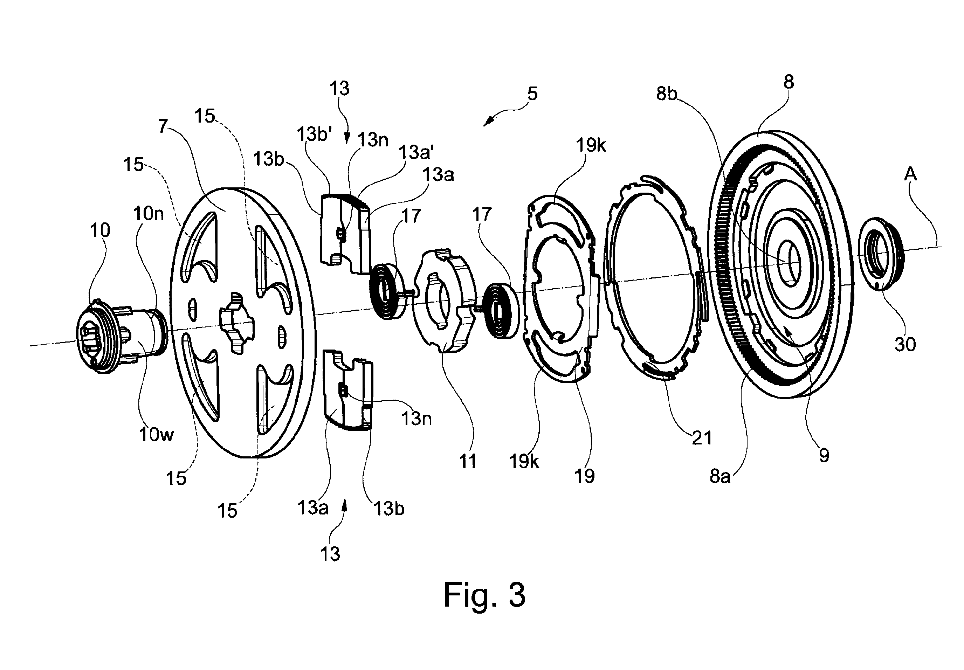

Der in den Figuren 2 und 3 dargestellte Beschlag 5 beruht auf dem gleichen Grundprinzip, wie ein beispielsweise aus der DE 102 53 054 A1 bekannter Rastbeschlag. Der Beschlag 5 weist ein erstes Beschlagteil 7 und ein relativ zu diesem um die Achse A verdrehbares zweites Beschlagteil 8 auf, welche zwischen sich einen Bauraum 9 definieren, der wesentliche Bauteile des Beschlages 5 in sich aufnimmt. Die beiden Beschlagteile 7 und 8 lassen sich jeweils näherungsweise in eine kreisrunde Scheibenform einbeschreiben. In baulicher Hinsicht bilden die beiden Beschlagteile 7 und 8 zusammen mit einem in den Figuren nicht dargestellten Umklammerungsring, wie dieser beispielsweise aus der EP 1 928 691 B1 bekannt ist, eine scheibenförmige Einheit. Der Umklammerungsring übergreift das zweite Beschlagteil 8 und ist mit dem ersten Beschlagteil 7 verbunden, wodurch die beiden Beschlagteile 7 und 8 axial zusammengehalten werden.

Nach der Montage des Beschlages 5 in den Fahrzeugsitz 1 ist das erste Beschlagteil 7 fest mit der Lehne 4 verbunden. Das zweites Beschlagteil 8 ist fest mit der Struktur des Sitzteils 3 verbunden. Die Zuordnungen der Beschlagteile 7 und 8 können jedoch auch vertauscht sein, d.h. das erste Beschlagteil 7 wäre dann sitzteilfest und das zweite Beschlagteil 8 lehnenfest.

Im Zentrum des Beschlages 5 ist ein Mitnehmer 10 angeordnet, welcher um die Achse A drehbar am zweiten Beschlagteil 8 gelagert ist. Auf dem Mitnehmer 10 sitzt drehfest oder wenigstens auf Mitnahme gekoppelt ein Exzenter 11. Der Exzenter 11 wirkt über an dessen Außenumfang verteilte Exzenternocken auf Riegelnocken von zwei Riegeln 13 ein. Die Riegel 13 sind um 180° versetzt zueinander im Bauraum 9 um den Exzenter 11 herum angeordnet und auf ihrer bezüglich der Achse A radial außen liegenden Seite (d.h. von den Riegelnocken abgewandten Seite) mit einer Verzahnung versehen, um mit einer als Zahnkranz 8a ausgebildeten Verzahnung des zweiten Beschlagteils 8 zusammenzuwirken. Die Riegel 13 werden in radialer Richtung durch Führungssegmente 15 des ersten Beschlagteils 7 geführt. Das zweite Beschlagteil 8 liegt mit dem Zahnkranz 8a auf den vier Führungssegmenten 15 auf, wodurch das zweite Beschlagteil 8 am ersten Beschlagteil 7 gelagert ist.

Eine Federanordnung 17 beaufschlagt den Exzenter 11, so dass dieser die Riegel 13 radial nach außen drückt, d.h. in die Verzahnung des Zahnkranzes 8a des zweiten Beschlagteils 8, womit der Beschlag 5 verriegelt ist. Eine Steuerscheibe 19 ist im Bauraum 9 axial zwischen den Riegeln 13 und dem zweiten Beschlagteil 8 angeordnet und sitzt vorliegend drehfest auf dem Exzenter 11. Die Steuerscheibe 19 weist zwei Kulissen 19k auf, von denen jede mit einer Nase 13n je eines Riegels 13 zusammenwirkt, wobei die Nasen 13n in axialer Richtung von den Riegeln 13 abstehen.

Ein in den Figuren nicht dargestellter Bedienhebel ist am Mitnehmer 10 befestigt, beispielsweise mittels eines profilierten Zapfens, der in den im Bereich der Achse A als profilierte Hohlwelle 10h ausgeführten Mitnehmer 10 eingesteckt wird und dadurch drehfest mit diesem verbunden ist.

Bei einer Betätigung des Bedienhebels und der daraus resultierenden Drehung des Mitnehmers 10 - und des damit angetriebenen Exzenters 11 und der Steuerscheibe 19 - entgegen der Kraft der Federanordnung 17 zieht die Steuerscheibe 19 die Riegel 13 radial nach innen, d.h. aus der Verzahnung des Zahnkranzes 8a, womit der Beschlag 5 entriegelt ist.

Der Mitnehmer 10 ist in einer Öffnung 8b des zweiten Beschlagteils 8 gelagert. Zwei angeformte Rippen des Mitnehmers 10 liegen in axialer Richtung an der Innenseite des zweiten Beschlagteils 8 an, während ein auf der Außenseite des zweiten Beschlagteils 8 angeordneter Sicherungsring 30 fest auf einem aus der Öffnung 8b des zweiten Beschlagteils 8 nach außen ragenden Wellenabschnitt 10w des Mitnehmers 10 sitzt, insbesondere auf diesen Wellenabschnitt 10 w aufgeclipst ist. Dazu weist der Wellenabschnitt 10w eine Nut 10n auf, in die eine Clipsgeometrie des Sicherungsrings 30 eingeclipst ist. Der Mitnehmer 10 ist damit axial gesichert.

Des Weiteren weist der Beschlag 5 eine an sich bekannte Freischwenkkulisse 21 auf, die ein Einfallen der Riegel 13 in den Zahnkranz 8a nur in definierten Winkellagen zwischen erstem Beschlagteil 7 und zweitem Beschlagteil 8 ermöglicht. Eine solche Freischwenkkulisse ist beispielsweise aus der DE 199 28 148 A1 bekannt.

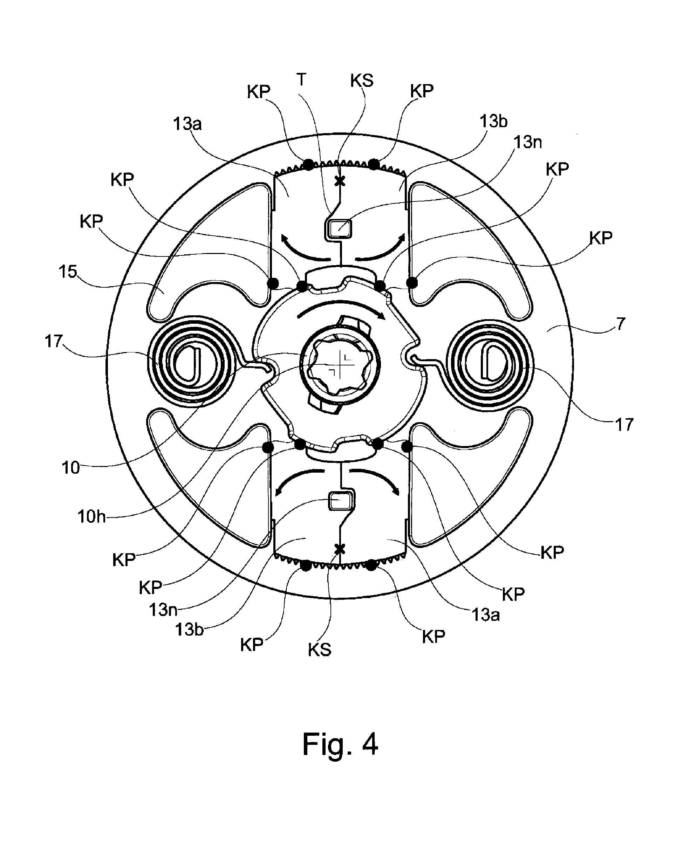

In Fig. 4 ist die Wirkungsweise der Spielreduzierung mittels der geteilten Riegel 13 näher dargestellt. Jeder der beiden Riegel 13 besteht aus einem ersten Riegelteil 13a und einem zweiten Riegelteil 13b. Eine Teilungslinie T zwischen erstem Riegelteil 13a und zweitem Riegelteil 13b verläuft vorliegend weitgehend in radialer Richtung und durchläuft auch die Verzahnung des Riegels 13, so dass diese Verzahnung ebenfalls geteilt ist. Das zweite Riegelteil 13b trägt jeweils die Nase 13n zum Zusammenwirken mit der Steuerscheibe 19.

Die Teilungslinie T, die den Riegel 13 in die beiden Riegelteile 13a und 13b teilt, weist Linienabschnitte auf, die von der radialen Richtung abweichen. Vorzugsweise weist die Teilungslinie T Abschnitte in Umfangsrichtung auf. Vorliegend verläuft die Teilungslinie (radial von innen aus gesehen) zunächst in radialer Richtung, knickt dann 90° in Umfangsrichtung zu dem ersten Riegelteil 13a hin ab und verläuft anschließend weiter in radialer Richtung, unterbrochen durch einen unter einem Winkel von 45° zur radialen Richtung verlaufenden Teilabschnitt.

Aufgrund der Führung der Riegelteile 13a und 13b zwischen den Führungsbahnen zweier Führungssegmente 15, die eine Relativbewegung der beiden Riegelteile 13a und 13b in Umfangsrichtung in einer über das Führungsspiel hinausgehenden Größenordnung verhindern, sind die beiden Riegelteile 13a, 13b auch in radialer Richtung weitgehend formschlüssig miteinander verbunden. Es ist nur eine geringe Relativbewegung, die erfindungsgemäß zum Spielausgleich erforderlich ist, möglich.

Das zweite Beschlagteil 8 ist aus Gründen der Übersichtlichkeit in der den verriegelten Zustand darstellenden Fig. 4 nicht abgebildet. Die Riegel 13 sind in die Verzahnung 8a des zweiten Beschlagteils 8 eingesteuert. Die Pfeile stellen die Bewegungsrichtung der Riegelteile 13a, 13b und des Exzenters 11 bei der Verriegelung dar.

Jeder Riegelteil 13a, 13b stützt sich über jeweils einen primären Kontaktpunkt KP auf einem Nocken des Exzenters 11 und über jeweils einen weiteren primären Kontaktpunkt KP an einer Führungsfläche des den jeweiligen Riegelteil 13a, 13b führenden Führungssegments 15 ab.

Unter primären Kontaktpunkten KP sind die Berührpunkte des Riegels 13 bzw. von dessen Riegelteilen 13a, 13b zu den Führungsbahnen der Führungssegmente 15, zu dem Exzenter 11 und zu dem Zahnkranz 8a des zweiten Beschlagteils 8 zu verstehen, die bei verriegeltem Beschlag 5 immer vorliegen. Berührpunkte, die nur unter hoher Last, insbesondere im Crashfall, Kräfte aufnehmen, sind nachfolgend als sekundäre Kontaktpunkte KS bezeichnet. Die primären Kontaktpunkte KP sind in Fig. 4 durch Punkte dargestellt. Des Weiteren ist in Fig. 4 jeweils ein sekundärer Kontaktpunkt KS zwischen erstem Riegelteil 13a und zweitem Riegelteil 13b durch ein Kreuz dargestellt. Unter normalen Betriebsbedingungen überträgt der sekundäre Kontaktpunkt KS keine Kräfte zwischen erstem Riegelteil 13a und zweitem Riegelteil 13b, sondern nur unter hoher Belastung, wie nachfolgend noch beschrieben wird.

Zur Verbesserung der Tragfähigkeit und der Festigkeit besitzt jedes Riegelteil 13a, 13b jeweils eine Verzahnung 13a', 13b' mit je einem weiteren, als Tragpunkt wirkenden primären Kontaktpunkt KP zur Verzahnung des Zahnkranzes 8a des zweiten Beschlagteils 8. Dies wird erreicht durch einen gegenüber der Verzahnung des Zahnkranzes 8a des zweiten Beschlagteils 8 reduzierten Grundkreisradius der Verzahnungen 13a', 13b' der Riegelteile 13a, 13b. Der Grundkreisradius ist dabei soweit reduziert, dass ein zur Spielreduzierung notwendiges Kippen der Riegelteile 13a, 13b durch Abwälzen der Verzahnungen 13a',13b' in dem Zahnkranz 8a des zweiten Beschlagteils 8 ermöglicht wird.

Die Riegel 13 sind derart geteilt, dass beide Riegelteile 13a und 13b in die Verzahnung des Zahnkranzes 8a des zweiten Beschlagteils 8 einfallen können und beide dort durch den Exzenter 11 selbsthemmend gehalten werden. Die Keilwinkel in den primären Kontaktpunkten KP zwischen den Riegelnocken und den Exzenternocken sind vorzugsweise kleiner als 5,7°, höchst vorzugsweise 4,3°.

Beim Entriegeln wird die Steuerscheibe 19 von dem sich drehenden Exzenter 11 mitgenommen und zieht mittels der Kulissen 19k die zweiten Riegelteile 13b mittels der dazu dienenden Nasen 13n aus dem Zahnkranz 8a radial nach innen, nachdem der Exzenter 11 beide Riegelteile 13a, 13b der beiden Riegel 13 freigegeben hat. Die zweiten Riegelteile 13b ziehen die ersten Riegelteile 13a durch ihre Formgebung in gleicher radialer Richtung mit aus dem Zahneingriff.

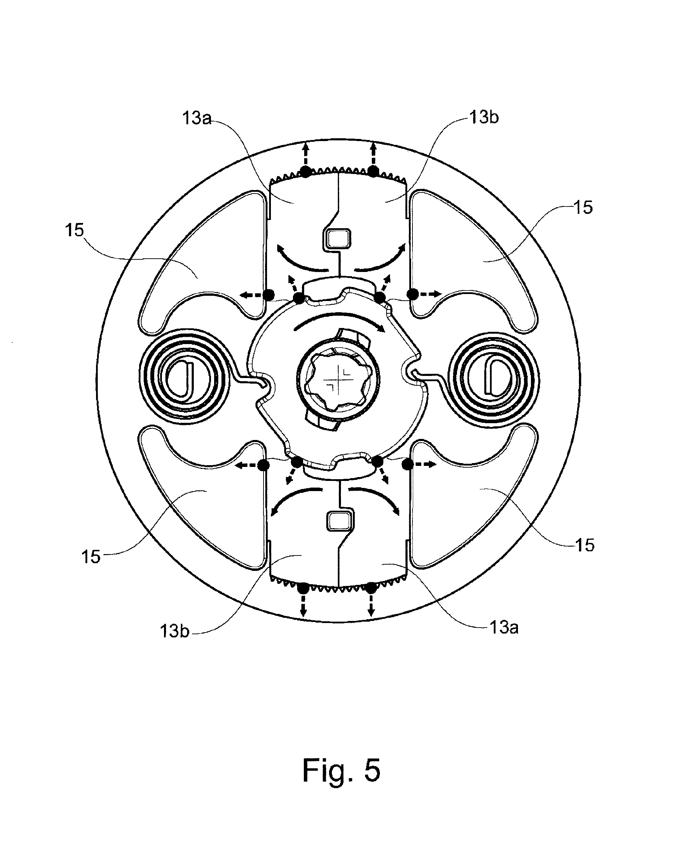

In Fig. 5 sind durch gestrichelte Pfeile die für die Spielreduzierung wichtigen wirksamen Kräfte dargestellt. Die Riegelteile 13a, 13b werden in den durch die Führungssegmente 15 des ersten Beschlagteils 7 gebildeten Führungsbahnen durch die von dem Exzenter 11 durch Federvorspannung eingeleiteten Kräfte vorgespannt. Die Vorspannung führt dazu, dass kein freies Spiel in der Führung übrig bleibt. Dazu ist das erste Riegelteil 13a, wie zuvor beschrieben, mittels seiner Verzahnung 13a' in einem primären Kontaktpunkt KP mit dem Zahnkranz 8a des zweiten Beschlagteils 8 in Zahneingriff. Durch die über die Exzenternocken des Exzenters 11 auf die Riegelnocken des ersten Riegelteils 13a aufgebrachte Kraft wirkt auf das Riegelteil 13a ein Drehmoment um den primären Kontaktpunkt KP zwischen erstem Riegelteil 13a und Zahnkranz 8a. Durch dieses Drehmoment erfährt das erste Riegelteil 13a eine Kippbewegung um diesen primären Kontaktpunkt KP, die das erste Riegelteil 13 a in die Richtung der dem ersten Riegelteil 13a zugeordneten Führungsbahn dreht und an diese andrückt.

Das zweite Riegelteil 13b wird in gleicher Weise, jedoch in anderer Drehrichtung von dem Exzenter 11 mit einer Kraft beaufschlagt und dadurch an die dem zweiten Riegelteil 13b zugeordnete Führungsbahn angedrückt. Durch die Drehungen der beiden Riegelteile 13a und 13b in unterschiedliche Drehrichtungen um den jeweils zu dem Zahnkranz 8a vorliegenden primären Kontaktpunkte KP wird das Spiel zwischen dem aus erstem Riegelteil 13a und zweitem Riegelteil 13b bestehenden Riegel vollständig eliminiert. In beide Belastungsrichtungen (in und gegen Fahrtrichtung) können dadurch direkt Kräfte übertragen werden, ohne dass zuvor ein freies Spiel durchfahren wird.

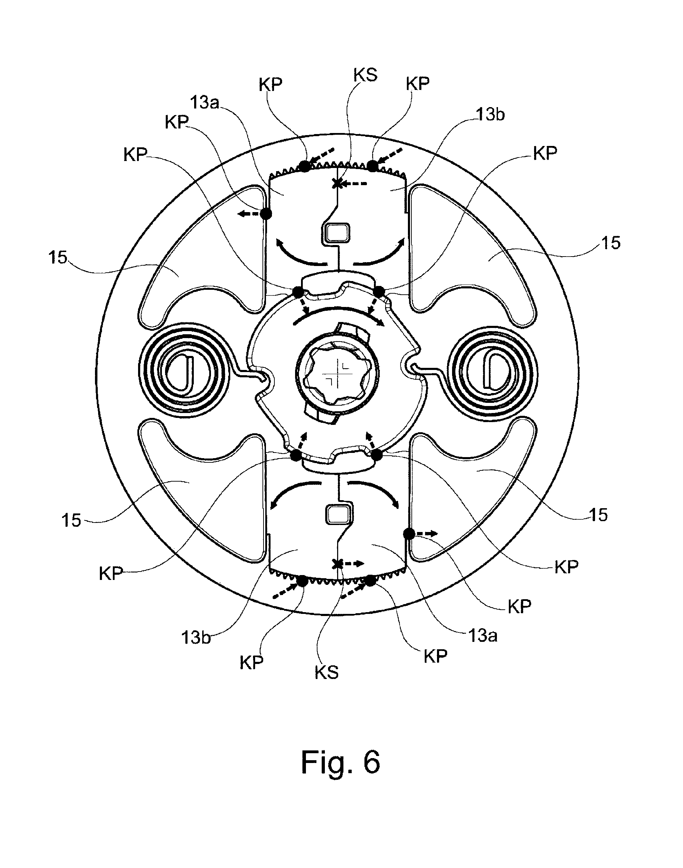

In Fig. 6 ist der Beschlag 5 bei höheren Belastungen dargestellt, wie sie zum Beispiel im Crashfall auftreten. Aufgrund der hohen Belastungen entsteht zwischen dem ersten Beschlagteil 7 und dem zweiten Beschlagteil 8 ein hohes Drehmoment um die Achse A. Dieses hohe Drehmoment bewirkt, aufgrund einer außerhalb der Selbsthemmung ausgelegten Verzahnung, in den primären Kontaktpunkten KP zwischen dem Zahnkranz 8a und den Verzahnungen 13a', 13b' resultierende Kräfte mit jeweils einer Kraftkomponente, die die Riegelteile 13a und 13b in radialer Richtung auf die Achse A hin belasten und somit öffnend wirken.

Aufgrund der gegenüber der Normallast veränderten Kraftrichtungen entsteht eine weitere Kraftübertragungsstelle zwischen dem ersten Riegelteil 13a und dem zweiten Riegelteil 13b, der sekundäre Kontaktpunkt KS. Je nach Ausgestaltung der Riegelteile 13a und 13b können diese im Normalbetrieb bereits unbelastet im Bereich des sekundären Kontaktpunktes KS aneinander anliegen. Im Crashfall werden die sekundären Kontaktpunkte KS jedoch kraftbeaufschlagt.

Es ist in Fig. 6 beispielhaft eine Belastungsrichtung dargestellt. Durch die primären Kontaktpunkte KP zwischen dem Exzenter 11 und den Riegelteilen 13a, 13b und durch die beiden primären Kontaktpunkte KP (Tragpunkte) zwischen den Verzahnungen 13a'und 13b' und dem Zahnkranz 8a können hohe Festigkeiten erzielt werden.

### Bezugszeichenliste

- 1: Fahrzeugsitz
- 3: Sitzteil
- 4: Lehne
- 5: Beschlag
- 7: erstes Beschlagteil
- 8: zweites Beschlagteil
- 8a: Zahnkranz
- 8b: Öffnung
- 9: Bauraum
- 10: Mitnehmer
- 10h: Hohlwelle
- 10n: Nut
- 10w: Wellenabschnitt
- 11: Exzenter
- 13: Riegel
- 13a: erstes Riegelteil
- 13a': Verzahnung
- 13b: zweites Riegelteil
- 13b': Verzahnung
- 13n: Nase
- 15: Führungssegment
- 17: Federanordnung
- 19: Steuerscheibe
- 19k: Kulisse
- 21: Freischwenkkulisse
- 30: Sicherungsring
- A: Achse
- KP: primärer Kontaktpunkt
- KS: sekundärer Kontaktpunkt
- T: Teilungslinie

## Patentansprüche

1. Beschlag (5) für einen Fahrzeugsitz (1), insbesondere für einen Kraftfahrzeugsitz, mit einem ersten Beschlagteil (7), einem relativ zu dem ersten Beschlagteil (7) um eine Achse (A) verdrehbaren zweiten Beschlagteil (8), einem antreibbaren und um die Achse (A) drehbar gelagerten Exzenter (11) und wenigstens einem Riegel (13), welcher von dem ersten Beschlagteil (7) in eine bezüglich der Achse (A) radiale Richtung beweglich geführt ist und welcher zum Verriegeln des Beschlags (5) von dem Exzenter (11) beaufschlagt radial nach außen bewegbar ist und radial außen mit dem zweiten Beschlagteil (8) zusammenwirkt, **dadurch gekennzeichnet, dass** der wenigstens eine Riegel (13) aus einem ersten Riegelteil (13a) und einem zweiten Riegelteil (13b) besteht und jedes der Riegelteile (13a, 13b) eine Verzahnung (13a', 13b') zum Zusammenwirken mit einer als Zahnkranz (8a) ausgebildeten Verzahnung des zweiten Beschlagteils (8) aufweist.

2. Beschlag (5) nach Anspruch 1, **dadurch gekennzeichnet, dass** der wenigstens eine Riegel (13) entlang einer Teilungslinie (T) in die zwei Riegelteile (13a, 13b) geteilt ist und die Teilungslinie (T) in Teilbereichen von der radialen Richtung abweicht.

3. Beschlag (5) nach Anspruch 1 oder 2, **gekennzeichnet durch** eine Steuerscheibe (19), welche drehfest mit dem Exzenter (11) verbunden ist und mit einer Nase (13n) des wenigstens einen Riegels (13) zusammenwirkt, um beim Entriegeln den Zahnkranz (8a) und den wenigstens einen Riegel (13) außer Eingriff zu bringen.

4. Beschlag (5) nach Anspruch 3, rückbezogen auf den Anspruch 2, **dadurch gekennzeichnet, dass** die Nase (13n) an dem zweiten Riegelteil (13b) des wenigstens einen Riegels (13) angeformt ist und die Teilungslinie (T) an der Nase (13n) vorbeigeführt ist.

5. Beschlag (5) nach einem der Ansprüche 3 bis 4, **dadurch gekennzeichnet, dass** das erste Riegelteil (13a) über einen Formschluss mit dem zweiten Riegelteil (13b) verbunden ist und beim Entriegeln des Beschlages (5) das erste Riegelteil (13a) mittels dieses Formschlusses von dem zweiten Riegelteil (13b) radial nach innen gezogen wird.

6. Beschlag (5) nach einem der Ansprüche 1 bis 5 **dadurch gekennzeichnet, dass** der Exzenter (11), insbesondere über Exzenternocken, die beiden Riegelteile (13a, 13b), insbesondere über Riegelnocken, in unterschiedliche Richtungen mit jeweils einer Kraft beaufschlagt, so dass die beiden Riegelteile (13a, 13b) mit Drehmomenten in zueinander entgegengesetzter Drehrichtung um jeweils einen primären Kontaktpunkt (KP) zwischen dem ersten Riegelteil (13a) und dem Zahnkranz (8a) und einen primären Kontaktpunkt (KP) zwischen dem zweiten Riegelteil (13b) und dem Zahnkranz (8a) beaufschlagt werden.

7. Beschlag (5) nach einem der Ansprüche 1 bis 6, **dadurch gekennzeichnet, dass** die Grundkreisradien der Verzahnungen (13a', 13b') des ersten Riegelteils (13a) und des zweiten Riegelteils (13b) gegenüber einem Grundkreisradius des Zahnkranzes (8a) kleiner sind.

8. Beschlag (5) nach einem der Ansprüche 1 bis 7, **dadurch gekennzeichnet, dass** ein Umklammerungsring das erste Beschlagteil (7) und das zweite Beschlagteil (8) axial zusammenhält.

9. Beschlag (5) nach einem der Ansprüche 1 bis 8, **dadurch gekennzeichnet, dass** der Beschlag (5) genau zwei Riegel (13) aufweist.

10. Fahrzeugsitz (1), insbesondere Kraftfahrzeugsitz, mit wenigstens einem Beschlag (5) nach einem der Ansprüche 1 bis 9.

## Claims

1. Fitting (5) for a vehicle seat (1), in particular for a motor vehicle seat, having a first fitting part (7), having a second fitting part (8) which is rotatable relative to the first fitting part (7) about an axis (A), having a driveable eccentric (11) which is mounted so as to be rotatable about the axis (A), and having at least one catch (13) which is guided by the first fitting part (7) so as to be movable in a radial direction with respect to the axis (A) and which, for the locking of the fitting (5), can be moved radially outward under the action of the eccentric (11) and interacts radially at the outside with the second fitting part (8), **characterized in that** the at least one catch (13) is composed of a first catch part (13a) and a second catch part (13b), and each of the catch parts (13a, 13b) has a toothing (13a', 13b') for interacting with a toothing, in the form of a toothed ring (8a), of the second fitting part (8).

2. Fitting (5) according to Claim 1, **characterized in that** the at least one catch (13) is split into the two catch parts (13a, 13b) along a parting line (T), and the parting line (T) deviates from the radial direction in regions.

3. Fitting (5) according to Claim 1 or 2, **characterized by** a control disk (19) which is connected rotationally conjointly to the eccentric (11) and which interacts with a lug (13n) of the at least one catch (13) in order, during the unlocking process, to move the toothed ring (8a) and the at least one catch (13) out of engagement.

4. Fitting (5) according to Claim 3, referring back to Claim 2, **characterized in that** the lug (13n) is integrally formed on the second catch part (13b) of the at least one catch (13), and the parting line (T) is guided past the lug (13n).

5. Fitting (5) according to either of Claims 3 and 4, **characterized in that** the first catch part (13a) is connected to the second catch part (13b) with a form fit, and during the unlocking of the fitting (5), the first catch part (13a) is pulled radially inward by the second catch part (13b) owing to said form fit.

6. Fitting (5) according to one of Claims 1 to 5, **characterized in that** the eccentric (11), in particular by way of eccentric cams, exerts a force on each of the two catch parts (13a, 13b), in particular by way of catch cams, in different directions, such that the two catch parts (13a, 13b) are subjected to torques in mutually opposite directions of rotation about in each case a primary contact point (KP) between the first catch part (13a) and the toothed ring (8a) and a primary contact point (KP) between the second catch part (13b) and the toothed ring (8a).

7. Fitting (5) according to one of Claims 1 to 6, **characterized in that** the base circle radius of the toothings (13a', 13b') of the first catch part (13a) and of the second catch part (13b) are smaller than a base circle radius of the toothed ring (8a).

8. Fitting (5) according to one of Claims 1 to 7, **characterized in that** a clasp ring holds the first fitting part (7) and the second fitting part (8) together axially.

9. Fitting (5) according to one of Claims 1 to 8, **characterized in that** the fitting (5) has precisely two catches (13).

10. Vehicle seat (1), in particular motor vehicle seat, having at least one fitting (5) according to one of Claims 1 to 9.

## Revendications

1. Ferrure (5) pour un siège de véhicule (1), en particulier pour un siège de véhicule automobile, comprenant une première partie de ferrure (7), une deuxième partie de ferrure (8) pouvant tourner par rapport à la première partie de ferrure (7) autour d'un axe (A), un excentrique (11) pouvant être entraîné et supporté de manière à pouvoir tourner autour de l'axe (A) et au moins un verrou (13) qui est guidé de manière déplaçable depuis la première partie de ferrure (7) dans une direction radiale par rapport à l'axe (A) et qui, pour verrouiller la ferrure (5), est déplaçable radialement vers l'extérieur de manière sollicitée par l'excentrique (11) et coopère radialement à l'extérieur avec la deuxième partie de ferrure (8), **caractérisée en ce que** l'au moins un verrou (13) se compose d'une première partie de verrou (13a) et d'une deuxième partie de verrou (13b) et chacune des parties de verrou (13a, 13b) présente une denture (13a', 13b') destinée à coopérer avec une denture de la deuxième partie de ferrure (8) réalisée sous forme de couronne dentée (8a).

2. Ferrure (5) selon la revendication 1, **caractérisée en ce que** l'au moins un verrou (13) est divisé le long d'une ligne de division (T) en les deux parties de verrou (13a, 13b) et la ligne de division (T) s'écarte de la direction radiale dans des régions partielles.

3. Ferrure (5) selon la revendication 1 ou 2, **caractérisée par** un disque de commande (19) qui est connecté de manière solidaire en rotation à l'excentrique (11) et qui coopère avec un ergot (13n) de l'au moins un verrou (13) afin de désengager la couronne dentée (8a) et l'au moins un verrou (13) lors du déverrouillage.

4. Ferrure (5) selon la revendication 3 lorsqu'elle se rapporte à la revendication 2, **caractérisée en ce que** l'ergot (13n) est façonné sur la deuxième partie de verrou (13b) de l'au moins un verrou (13) et la ligne de division (T) passe devant l'ergot (13n).

5. Ferrure (5) selon l'une quelconque des revendications 3 à 4, **caractérisée en ce que** la première partie de verrou (13a) est connectée par le biais d'un engagement par correspondance de formes à la deuxième partie de verrou (13b) et, lors du déverrouillage de la ferrure (5), la première partie de verrou (13a) est tirée radialement vers l'intérieur par la deuxième partie de verrou (13b) au moyen de cet engagement par correspondance de formes.

6. Ferrure (5) selon l'une quelconque des revendications 1 à 5, **caractérisée en ce que** l'excentrique (11), en particulier par le biais de cames d'excentrique, sollicite les deux parties de verrou (13a, 13b), en particulier par le biais de cames de verrou ; avec à chaque fois une force dans des directions différentes, de sorte que les deux parties de verrou (13a, 13b) soient soumises à des couples dans des directions de rotation mutuellement opposées autour d'un point de contact primaire respectif (KP) entre la première partie de verrou (13a) et la couronne dentée (8a) et d'un point de contact primaire (KP) entre la deuxième partie de verrou (13b) et la couronne dentée (8a).

7. Ferrure (5) selon l'une quelconque des revendications 1 à 6, **caractérisée en ce que** les rayons du cercle de base des dentures (13a', 13b') de la première partie de verrou (13a) et de la deuxième partie de verrou (13b) sont plus petits que le rayon de cercle de base de la couronne dentée (8a).

8. Ferrure (5) selon l'une quelconque des revendications 1 à 7, **caractérisée en ce qu'**une bague de serrage retient axialement la première partie de ferrure (7) et la deuxième partie de ferrure (8).

9. Ferrure (5) selon l'une quelconque des revendications 1 à 8, **caractérisée en ce que** la ferrure (5) présente exactement deux verrous (13).

10. Siège de véhicule (1), en particulier siège de véhicule automobile, comprenant au moins une ferrure (5) selon l'une quelconque des revendications 1 à 9.
